# EUROPEAN PATENT SPECIFICATION

(11) **EP 2 731 149 B1**
(45) Date of publication and mention of the grant of the patent: **29.03.2017**
(21) Application number: 13191914.4
(22) Date of filing: 07.11.2013
(51) Int. Cl.: H01L 21/02, H01L 33/20, H01L 33/00, H01L 33/12, H01L 33/16

(54) **Light emitting device**
Lichtemittierende Vorrichtung
Dispositif électroluminescent

(30) Priority: 07.11.2012 KR 20120125165
(43) Date of publication of application: 14.05.2014
(73) Proprietor: LG Innotek Co., Ltd., Seoul 100-714 (KR)
(72) Inventor: Kim, Sang Il, 100-714 Seoul (KR); Kang, Dong Hun, 100-714 Seoul (KR); Na, Jong Ho, 100-714 Seoul (KR); Song, Yong Seon, 100-714 Seoul (KR)
(74) Representative: Zardi, Marco

(56) References cited:
- WO-A1-2012/148039
- US-A1- 2008 303 042
- US-A1- 2010 015 739
- US-A1- 2011 140 127
- US-A1- 2012 083 063

## Description

### BACKGROUND

The embodiment relates to a light emitting device.

The embodiment relates to a light emitting device package.

Studies for a light emitting device package having a light emitting device have been actively pursued.

A light emitting device, which is made of, for example, a semiconductor material, is a semiconductor light emitting device or a semiconductor light emitting diode to convert electrical energy into light energy.

When comparing with conventional light sources such as a fluorescent lamp, and an incandescent lamp, the semiconductor light emitting device has advantages such as low power consumption, a semi-permanent life span, a rapid response speed, safety, and an eco-friendly property. In this regard, various studies have been performed to replace the conventional light sources with the LEDs.

The light emitting devices or light emitting device packages are increasingly used as light sources for lighting devices, such as various lamps used in indoors and outdoors, liquid crystal displays, electric signboards, and street lamps. WO 2012/148039A1 discloses flat and thin semiconductor substrate, which is formed on a heterogeneous substrate to be easily lifted-off from the heterogeneous substrate. US 2010/0015739A1 discloses a semiconductor light emitting device manufacturing method wherein a surface of a substrate, on which the semiconductor light emitting device is to be manufactured, is etched, thus forming a plurality of deep trenches. US 2012/0083063A1 discloses a Group III nitride semiconductor light-emitting device including an n-type layer, a light-emitting layer, and a p-type layer, each of the layers being formed of Group III nitride semiconductor, being sequentially deposited via a buffer layer on a textured sapphire substrate. US 2008/0303042 A1 discloses a light emitting element having a recess-protrusion structure.

### SUMMARY

The embodiment provides a light emitting device capable of improving a light extraction.

The embodiment provides a light emitting device which can be grown in a good quality.

The embodiment provides a light emitting device package including a light emitting device.

According to the embodiment, there is provided a light emitting device including a substrate; a plurality of protrusions disposed on the substrate and spaced apart from each other; a first semiconductor layer on top surfaces of the protrusions; a medium layer between the protrusions; and a light emitting structure on the first semiconductor layer, wherein the first semiconductor layer is formed along a c-plane of the protrusions, and a bottom surface of the first semiconductor layer includes a seed pattern.

According to the embodiment, there is provided a light emitting device package includes a body; first and second lead electrodes on the body; a light emitting device on one of the first and second lead electrodes; and a molding member surrounding the light emitting device.

### BRIEF DESCRIPTION OF THE DRAWINGS

FIG. 1 is a sectional view showing a light emitting device according to an embodiment.
FIG. 2 is a perspective view showing the light emitting device of FIG. 1.
FIG. 3 is a perspective view showing the substrate of FIG. 1.
FIG. 4 is a plane view showing the substrate of FIG. 1.
FIGS. 5 to 9 are views illustrating a process of fabricating a light emitting device according to an embodiment.
FIG. 10 is a sectional view showing a lateral-type light emitting device according to an embodiment.
FIG. 11 is a sectional view showing a flip-type light emitting device according to an embodiment.
FIG. 12 is a sectional view showing a vertical-type light emitting device according to an embodiment.
FIG. 13 is a sectional view showing a light emitting device package according to an embodiment.

### DETAILED DESCRIPTION OF THE EMBODIMENTS

In the following description of the embodiments, it will be understood that, when an element is referred to as being formed "on" or "under" another element, two elements may make direct contact with each other, or one or more element may be interposed between two elements. Further, it will be understood that, when an element is referred to as being "on" or "under" another element, the element may be formed in an upper or down direction based on one element.

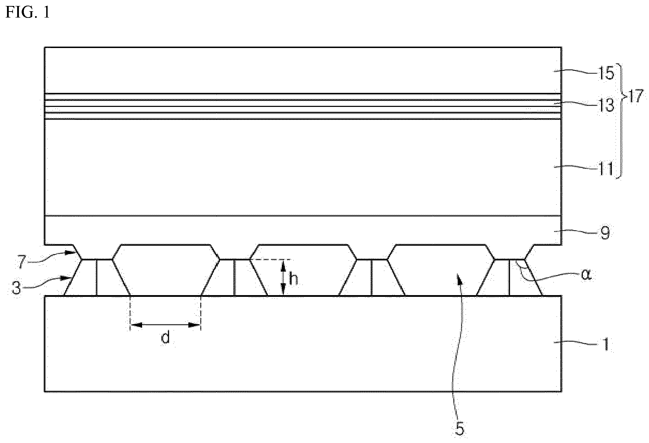

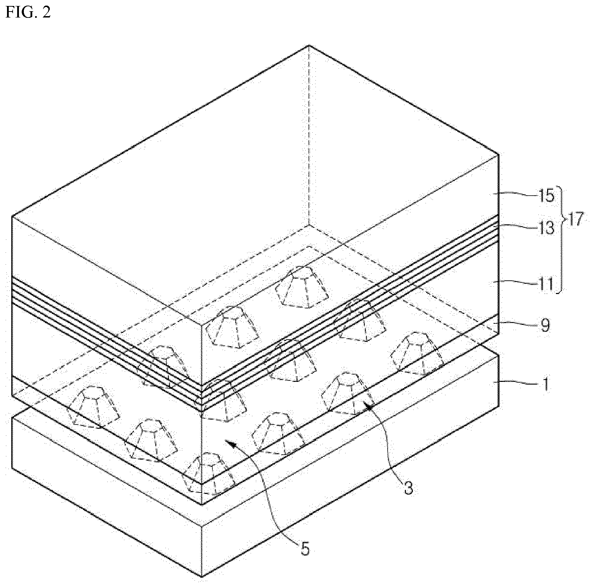

FIG. 1 is a sectional view showing a light emitting device according to an embodiment. FIG. 2 is a perspective view showing the light emitting device of FIG. 1.

Referring to FIG. 1, the light emitting device according to the embodiment may include a substrate 1, a first semiconductor layer 9 and a light emitting structure 17, but the embodiment is not limited thereto.

The light emitting structure 17 may include a first conductive semiconductor layer 11, an active layer 13, and a second conductive semiconductor layer 15, but the embodiment is not limited thereto.

The light emitting device according to the embodiment may further include another semiconductor layer (not shown) disposed under and/or on the light emitting structure 17.

The light emitting device according to the embodiment may further include an undoped semiconductor layer (not shown) interposed between the first semiconductor layer 9 and the light emitting structure 17.

The substrate 1 performs a function of easily growing the light emitting structure 17, but the embodiment is not limited thereto.

In order to stably grow the light emitting structure 17, the substrate 1 may include a material making a smaller lattice constant difference from that of the light emitting structure 10.

The light emitting device according to the embodiment may include a plurality of protrusions 3 protruding from a top surface of the substrate 1. The substrate 1 and the protrusions 3 may be formed the same material such as sapphire.

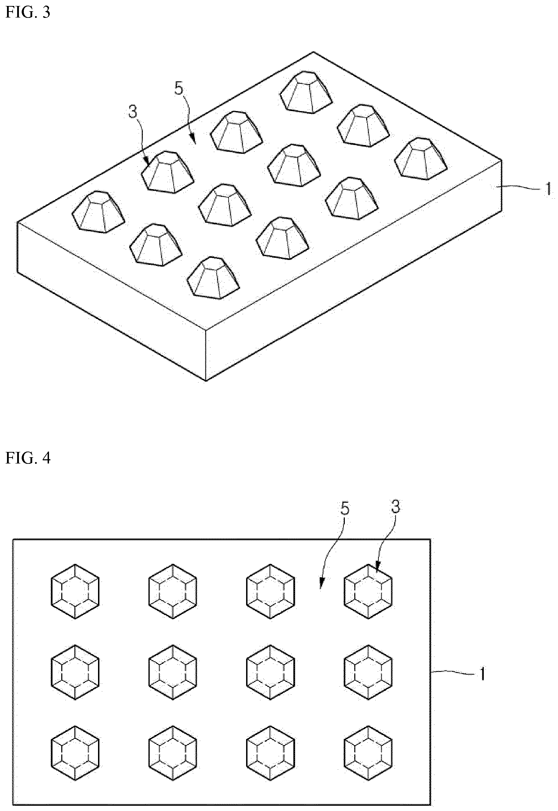

As shown in FIGS. 3 and 4, each protrusion 3 may have a hexahedral shape, but the embodiment is not limited thereto. That is, each protrusion 3 may have one top surface and six side surfaces, but the embodiment is not limited thereto. Each top surface of the protrusions 3 is 14.

The gap between the protrusions 3 may be constant or random, but the embodiment is not limited thereto.

The protrusions 3 may have a regular shape or a random shape, but the embodiment is not limited thereto.

A side of the protrusion 3 may have an inclined surface to the top surface of the substrate 1, but the embodiment is not limited thereto.

For example, the side surface of the protrusion 3 may have an angle α in the range of 90° to 150° with respect to the top surface of the protrusion 3, but the embodiment is not limited thereto.

For example, the protrusion 3 may have a height h in the range of 2µm to 4µm, but the embodiment is not limited thereto. For example, the top surface of the protrusion 3 may include a flat surface, but the embodiment is not limited thereto. For example, a gap d between the protrusions 3 may be in the range of 1µm to 20µm when measured at bottoms of the protrusions 3, but the embodiment is not limited thereto.

A size of the upper portion of the protrusion 3 may be smaller than that of the lower portion of the protrusion 3, but the embodiment is not limited thereto.

The first semiconductor layer 9 may be formed on the top surface of the protrusion 3. A seed pattern 7, which makes contact with the top surface of the protrusion 3, may be formed on the bottom surface of the first semiconductor layer 9.

As the first semiconductor layer 9 is more grown, the seed patterns 7 may be merged with each other.

The seed pattern 7 may be easily grown along c-plane of the protrusion 3 and the seed pattern 7 is rarely grown in the direction having an angle of ±15° with respect to a-plane of the protrusion 3. The seed pattern 7 is more easily grown in an a-plane direction than the direction having an angle of ±15° with respect to a-plane. That is, the seed pattern 7 is rarely grown in the direction having an angle of ±15° with respect to a-plane of the protrusion 3, the seed pattern 7 is more easily grown in the a-plane direction than the direction having an angle of ±15° with respect to the a-plane of the protrusion 3, and the seed pattern 7 may be grown best along c-plane of the protrusion 3.

Thus, although not shown, a side surface of the seed pattern 7 may have a concave-convex shape partly protruding in a side direction along the circumference of the seed pattern 7, but the embodiment is not limited thereto. In this case, a concave portion may be formed at ±15° about the a-plane of the protrusion 3 and a convex portion may be aligned in the a-plane direction of the protrusion 3, but the embodiment is not limited thereto.

The side shape and height of the seed pattern 7 may be changed according to the growing temperature and pressure, but the embodiment is not limited thereto.

The side surface of the seed pattern 7 may be symmetrical or asymmetrical to the side surface of the protrusion 3, but the embodiment is not limited thereto. The bottom surface of each seed pattern 7 may have a polygon shape such as a hexagonal shape, but the embodiment is not limited thereto. The bottom surface of each seed pattern 7 and the top surface of each protrusion 3 may be formed in the hexagon shape, and have mutually different sizes or the same size. The edges of each seed pattern 7 may be offset from the edges of each protrusion 3. For example, each edge of the seed patterns 7 may correspond to each inclined side surface of the protrusions 7.

All of the bottom surfaces of the seed patterns 7 overlap with the top surfaces of the protrusions 3 in a vertical direction. A width of the bottom surface of each seed pattern 7 may be equal to or less than that of the bottom surface of each protrusion 3. An area of the bottom surface of each seed pattern 7 may be equal to or less than that of the bottom surface of each protrusion 3. A thickness of the bottom surface of each seed pattern 7 may be thinner than the height h of the bottom surface of each protrusion 3. In addition, the bottom surface of the first semiconductor layer 9 may be placed at a position higher than that of the top surface of the protrusion 3.

Since the first semiconductor layer 9 is formed through the seed pattern 7, the possibility of causing a dislocation may be minimized, so that the layer quality of the first semiconductor layer 9 may be improved and the layer quality of the light emitting structure 17 formed on the first semiconductor layer 9 may be excellent.

Even though a dislocation is formed on the seed pattern 7, the seed pattern 7 is formed in a horizontal direction rather than a vertical direction due to the growing direction, so that the dislocation is formed on the first semiconductor layer 9 in the horizontal direction. Thus, the dislocation formed on the first semiconductor layer 9 in the horizontal direction does not exert influence on the light emitting structure 17 formed on the first semiconductor layer 9, so that any dislocations may be not caused in the light emitting structure 17, so the layer quality may be excellent and the optical and electrical characteristics may be improved.

Since the seed pattern 7 and the first semiconductor layer 9 are formed on the protrusion 3, a medium layer 5 may be formed by the substrate 1, the protrusion 3, the seed pattern 7 and the first semiconductor layer 9. The medium layer 5 may include air, but the embodiment is not limited thereto. That is, after a passage passing through an outside of the medium layer 5 of the light emitting device is closed, a liquid such as oil may be formed in the medium layer 5.

The first semiconductor layer 9 may be formed to alleviate a lattice constant difference between the substrate 1 and the light emitting structure 17. The first semiconductor layer 9 may be a buffer layer.

The first semiconductor layer 9 may be formed of a group II-VI compound semiconductor material or a group III-V compound semiconductor material. For example, the first semiconductor layer 9 may be formed in a multiple-layer structure including at least one of GaN, InN, AlGaN and InGaN, but the embodiment is not limited thereto.

The light emitting structure 17 may be formed on the first semiconductor layer 9. For example, the light emitting structure 17 may include the first conductive semiconductor layer 11, the active layer 13 and the second conductive semiconductor layer 15. The first conductive semiconductor layer 11 may be formed on the first semiconductor layer 9, the active layer 13 may be formed on the first conductive semiconductor layer 11, and the second conductive semiconductor layer 15 may be formed on the active layer 13.

For example, the first conductive semiconductor layer 11 may be an N-type semiconductor including an N-type dopant. For example, the first conductive semiconductor layer 11 may be formed of the semiconductor material having the compositional formula of InₓAl_{y}Ga_{1-x-y}N (0≤x≤1, 0≤y≤1, 0≤x+y≤1). For example, the first conductive semiconductor layer 11 may include at least one selected from the group consisting of InAlGaN, GaN, AlGaN, InGaN, AlN, InN and AlInN, and may be doped with an N-type dopant such as Si, Ge or Sn.

The active layer 13 may be formed on the first conductive semiconductor layer 11.

The active layer 13 emits light having a wavelength corresponding to an energy band gap between the materials constituting the active layer 13 by combining the first carrier, for example, electrons injected through the first conductive semiconductor layer 11 with the second carrier, for example, holes.

The active layer 13 may include one of an SQW (single quantum well) structure, an MQW (multiple quantum well) structure, a quantum wire structure or a quantum dot structure. The active layer 13 may have the stack structure in which a cycle of well and barrier layers including group II-VI or III-V compound semiconductors are repeatedly formed. For example, the active layer 7 may be formed in the stack structure of InGaN/GaN, InGaN /AlGaN, InGaN/InGaN. The energy bandgap of the barrier layer may be greater than energy the bandgap of the well layer.

The second conductive semiconductor layer 15 may be formed on the active layer 13. For example, the second conductive semiconductor layer 15 may include a P-type semiconductor layer including P-type dopants. The second conductive semiconductor layer 15 may be formed of a semiconductor material having the compositional formula of InxAlyGal-x-yN (0≤x≤1, 0≤y≤1, and 0≤x+y≤1). For example, the second conductive semiconductor layer 15 may include at least one selected from the group consisting of InAlGaN, GaN, AlGaN, InGaN, AlN, InN and AlInN, and may be doped with P-type dopants such as Mg, Zn, Ca, Sir, or Ba.

Although it is described in the embodiment that the first semiconductor layer 9 is formed on the protrusion 3, the first conductive semiconductor layer 11 of the light emitting structure 17 may be directly formed on the protrusion 3 of the first conductive semiconductor layer 11 instead of the first semiconductor layer 9, but the embodiment is not limited thereto. The first semiconductor layer 9 may be a buffer layer, an N-type semiconductor layer or a P-type semiconductor layer.

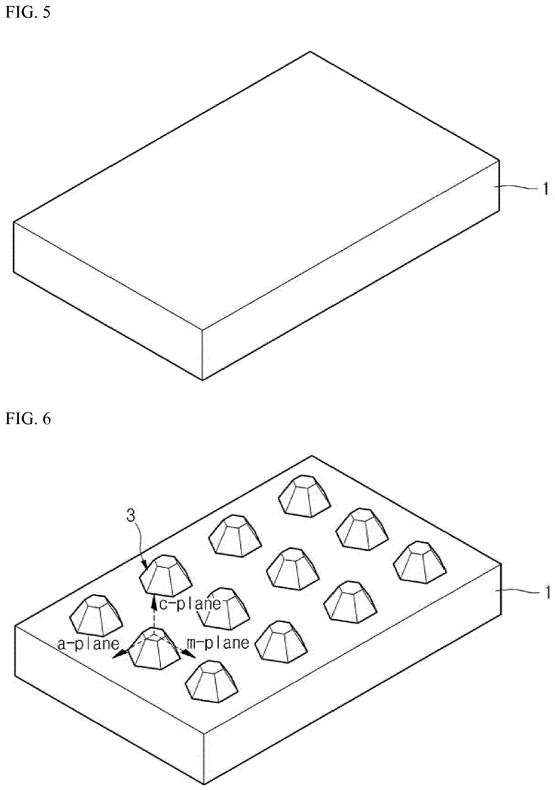

FIGS. 5 to 9 are views illustrating a process of fabricating a light emitting device according to an embodiment.

Referring to FIG. 5, the substrate 1 may be prepared. In order to stably grow the light emitting structure 17, the substrate 1 may include a material making a smaller lattice constant difference from that of the light emitting structure 17.

The substrate 1 may include at least one selected from the group consisting of Al₂O₃, SiC, Si, GaAs, GaN, ZnO, Si, GaP, InP and Ge.

Referring to FIG. 6, the plurality of protrusions 3 may be formed by etching the top surface of the substrate 1.

The protrusion 3 may be formed in a hexahedral shape, but the embodiment is not limited thereto.

The direction between the side surfaces of the protrusion 3 may be an a-plane, the direction of the side surface of the protrusion 3 may be an m-plane, and the direction of the top surface of the protrusion 3 may be a c-plane.

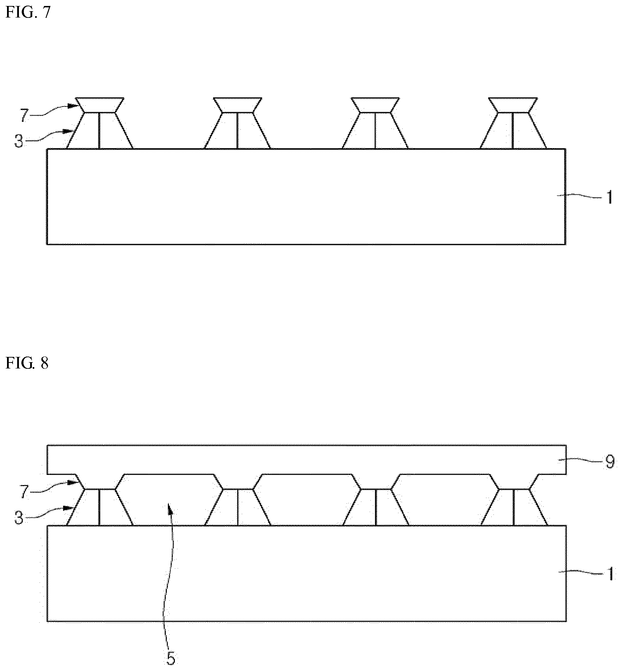

Referring to FIG. 7, the seed pattern 7 may be formed on the top surface of the protrusion 3. The seed pattern 7 may have a function of forming the first semiconductor layer 9 in a subsequent process and may be formed of the same material as that of the first semiconductor layer 9.

The seed pattern 7 and the first semiconductor layer 9 may be formed of a group II-VI compound semiconductor material or a group III-V compound semiconductor material.

Atoms of the compound semiconductor material of the seed pattern 7 may be arrayed at 30° about atoms of the protrusion 3, but the embodiment is not limited thereto.

The seed pattern 7 is grown at the fastest speed in the c-plane direction corresponding to the top surface of the protrusion 3, is grown at the slower speed in the direction of ±15° about the a-plane than that of the c-plane direction, and is not grown in the a-plane direction.

Thus, the side surface of the seed pattern 7 may have an inclined surface to the top surface of the protrusion 3, and may be symmetrical or asymmetrical with the side surface of the protrusion 3 about the top surface of the protrusion 3, but the embodiment is not limited thereto.

The side surface of the seed pattern 7 may have a concave-convex shape partly protruding along a periphery of the side surface in a side direction, but the embodiment is not limited thereto.

Referring to FIG. 8, the first semiconductor layer 9 is continuously grown on the seed pattern 7 with the same material as that of the seed pattern 7, so that the first semiconductor layer 9 may be combined between the seed patterns 7.

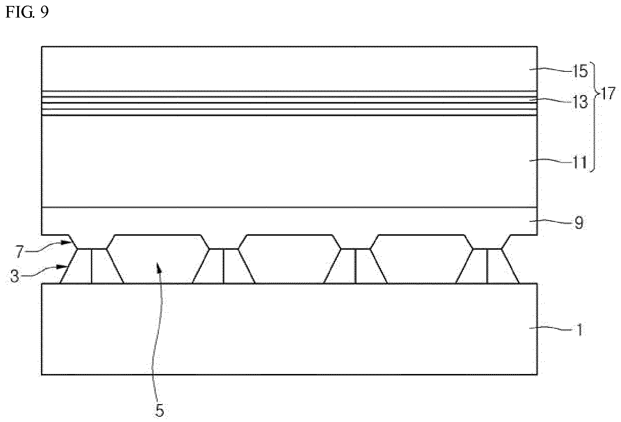

Referring to FIG. 9, the light emitting structure 17 including the first conductive semiconductor layer 11, the active layer 13 and the second conductive semiconductor layer 15 may be formed on the first semiconductor layer 9.

The first semiconductor layer 9 and the light emitting structure 17 may be formed of a group II-VI or III-V compound semiconductor material, but the embodiment is not limited thereto.

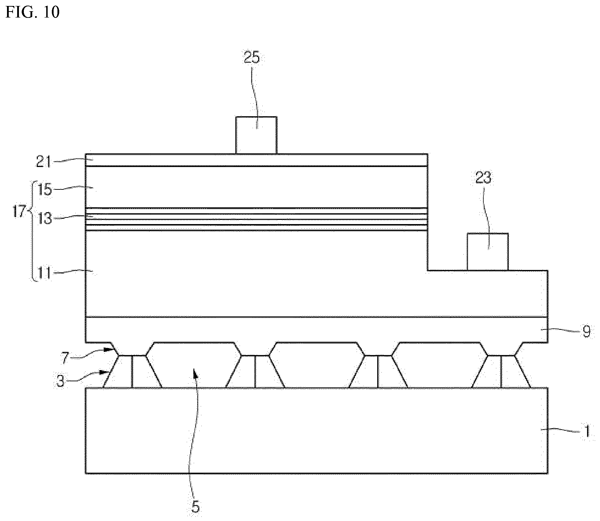

FIG. 10 is a sectional view showing a lateral-type light emitting device according to the embodiment.

Referring to FIG. 10, the lateral-type light emitting device may include a substrate 1, a medium layer 5, a first conductive semiconductor layer 11, an active layer 13, a second conductive semiconductor layer 15, a transparent conductive layer 21 and first and second electrodes 23 and 25.

In the embodiment of FIG. 10, the same reference numerals will be assigned to elements having the same functions as those of FIG. 1, and details thereof will be omitted in order to avoid redundancy.

A plurality of protrusions 3 may be formed on the substrate 1 and the medium layer 5 may be formed by the protrusions 3, for example, in spaces between the protrusions 3, but the embodiment is not limited thereto.

The medium layer 5 may be a liquid such as oil or air, the embodiment is not limited thereto.

The medium layer 5 may be surrounded by the substrate 1, the protrusion 3, the seed pattern 7 and the first semiconductor layer 9.

The seed pattern 7 may be formed on the bottom surface of the first semiconductor layer 9 and may make contact with the top surface of the protrusion 3.

The first conductive semiconductor layer 11, the active layer 13 and the second conductive semiconductor layer 15 may constitute the light emitting structure 17.

A transparent conductive layer 21 may be formed on the second conductive semiconductor layer 15 and a second electrode 25 may be formed in a region on the transparent conductive layer 21.

A first electrode 23 may be formed in a region on the first conductive semiconductor layer 11. To this end, through a mesa etching, the second conductive semiconductor layer 15, the active layer 13 and a portion of the top surface of the first conductive semiconductor layer 11 may be removed. Then, the first electrode 23 may be formed the first conductive semiconductor layer 11.

Since the second electrode 25 is formed on the uppermost portion of the lateral-type light emitting device and the first electrode 23 is formed on a side surface of the lateral-type light emitting device according to the embodiment, when an electric power is applied to the first and second electrodes 23 and 25, current flows into the light emitting structure 17 which is the shortest path between the first and second electrodes 23 and 25, so that any light may be not emitted from the entire region of the active layer 13.

Therefore, since the transparent conductive layer 21 is formed on the entire region of the second conductive semiconductor layer 15 between the second conductive semiconductor layer 15 and the second electrode 25, the current spreads over the entire region of the transparent conductive layer 21 through the second electrode 25 so that the current flows between the first electrode 23 and the entire region of the transparent conductive layer 21. Thus, the light is emitted from the entire region of the active layer 13 so that the light emitting efficiency may be improved.

The transparent conductive layer 21 may be formed of a conductive material having excellent transparence and conductivity. For example, the transparent conductive layer 21 may include at least one selected from the group consisting of ITO, IZO(In-ZnO), GZO(Ga-ZnO), AZO(Al-ZnO), AGZO(Al-Ga ZnO), IGZO(In-Ga ZnO), IrOx, RuOx, RuOx/ITO, Ni/IrOx/Au and Ni/IrOx/Au/ITO.

For example, the first and second electrodes 23 and 25 may include one selected from the group consisting of Al, Ti, Cr, Ni, Pt, Au, W, Cu and Mo, or an alloy thereof, but the embodiment is not limited thereto.

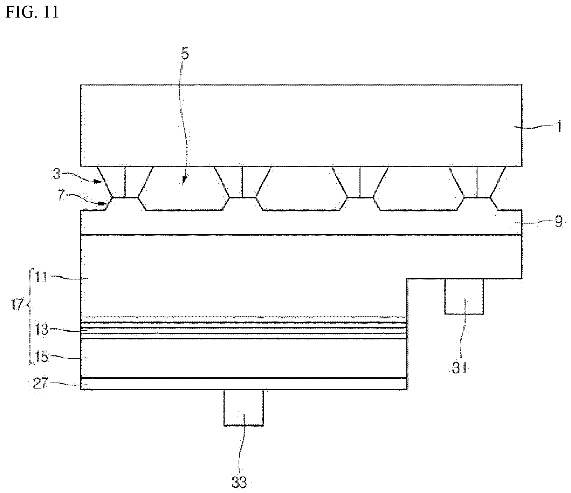

FIG. 11 is a sectional view showing a flip-type light emitting device according to the embodiment.

The embodiment of FIG. 11 is almost similar with that of FIG. 10, except for a reflective layer 27 substituting for the transparent conductive layer 21 of FIG. 10. Thus, in the embodiment of FIG. 11, the same reference numerals will be assigned to elements having the same shapes and functions as those of FIG. 10, and details thereof will be omitted in order to avoid redundancy.

Referring to FIG. 11, the flip-type light emitting device may include a substrate 1, a medium layer 5, a first conductive semiconductor layer 11, an active layer 13, a second conductive semiconductor layer 15, a reflective layer 27 and first and second electrodes 31 and 33.

The first conductive semiconductor layer 11, the active layer 13 and the second conductive semiconductor layer 15 may constitute the light emitting structure 17.

The reflective layer 27 may be formed below the second conductive semiconductor layer 15 and the second electrode 33 may be formed below the reflective layer 27.

The reflective layer 27 may be formed below the active layer 13 such that the light propagated in a lower direction may be reflected. The reflective layer 27 may include at least one selected from the group consisting of Ag, Ni, Al, Rh, Pd, Ir, Ru, Mg, Zn, Pt, Au and Hf, or a lamination thereof, but the embodiment is not limited thereto.

The first electrode 31 may be formed below the first conductive semiconductor layer 11.

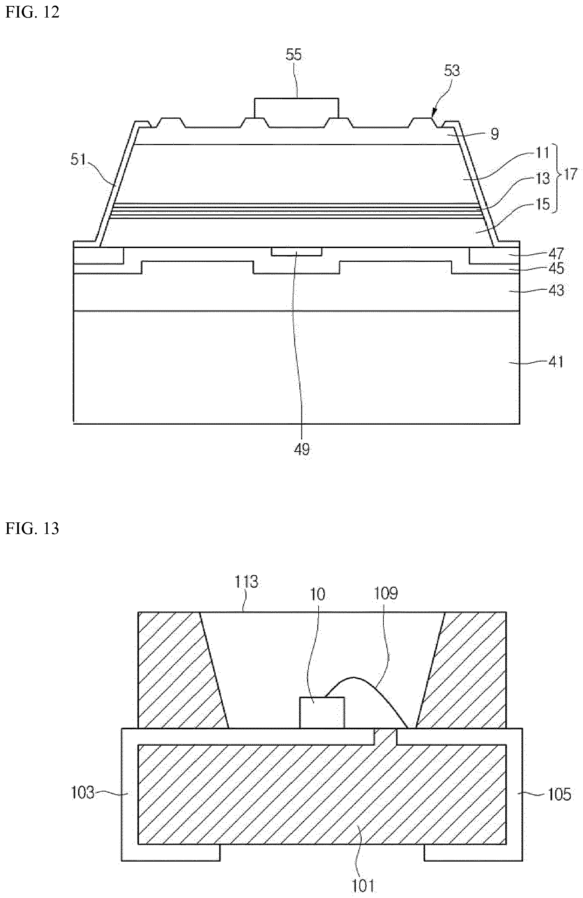

FIG. 12 is a sectional view showing a vertical-type light emitting device according to the embodiment.

Instead of the first and second electrodes 23 and 25 of FIG. 10 or the first and second electrodes 31 and 33 of FIG. 11, an electrode 55 and an electrode layer 45 are provided in the embodiment of FIG. 12, where the electrode 55 and the electrode layer 45 may be vertically overlapped with each other. In addition, in the embodiment of FIG. 12, since the electrode layer 45 at least has a size and reflexibility greater than those of the active layer 13 of the light emitting structure 17, the electrode layer 45 may reflect forward the light generated from the active layer 13, so that the light emitting efficiency may be improved.

An electrode 55 of the embodiment of FIG. 12 may have the same structure, shape, material and function as those of the first and second electrodes 23 and 25 of FIG. 10 or the first and second electrodes 31 and 33 of FIG. 11. Thus the detailed description of the electrode 55 of FIG. 12 will be omitted and the omitted description will be easily understood by referring to the above description.

Referring to FIG. 12, the vertical-type light emitting device according to the embodiment may include a supporting substrate 41, a bonding layer 43, an electrode layer 45, a current blocking layer (CBL) 49, a first conductive semiconductor layer 11, an active layer 13, a second conductive semiconductor layer 15, a light extraction structure 53, a protective layer 51 and an electrode 55.

The first conductive semiconductor layer 11, the active layer 13 and the second conductive semiconductor layer 15 may constitute the light emitting structure 17.

The supporting substrate 41, the bonding layer 43 and the electrode layer 45 may constitute an electrode member for supplying electric power.

The supporting substrate 41 may support a plurality of layers thereon and may perform an electrode function. The supporting substrate 41 may supply an electric power to the electrode 55 and the light emitting structure 17.

The supporting substrate 41 may be formed of a metallic material or a semiconductor material, but the embodiment is not limited thereto. The supporting substrate 41 may be formed of a material having high electrical conductivity and thermal conductivity. For example, the supporting substrate 41 may be a metallic material including at least one selected from the group consisting of Ti, Cr, Ni, Al, Pt, Au, W, Cu, Cu alloy, Mo and Cu-W For example, the supporting substrate 41 may be a semiconductor material including at least one selected from the group consisting of Si, Ge, GaAs, GaN, ZnO, SiGe and SiC.

The bonding layer 43 may be formed on the supporting substrate 41. The bonding layer 43 is formed between the electrode layer 45 and the supporting substrate 41. The bonding layer 43 may serve as a medium for enhancing the adhesion between the electrode layer 45 and the supporting substrate 41.

The bonding layer 43 may be formed of a metallic material having high bonding characteristic and thermal conductivity. For example, the bonding layer 43 may include at least one selected from the group consisting of Ti, Au, Sn, Ni, Nb, Cr, Ga, In, Bi, Cu, Ag and Ta.

The top surface of the bonding layer 43 may have a groove which is formed to allow the periphery region to extend in the upper direction, that is, toward the light emitting structure 17, the embodiment is not limited thereto. The electrode layer 43 may make contact with the central region of the top surface of the bonding layer 43 or may be formed on the groove, but the embodiment is not limited thereto.

Some region of the electrode layer 45 may vertically overlap with a bottom surface of the channel layer 47. In other words, the inner region of the channel layer 47 may pass through an end of the electrode layer 45 and extend to an inside of the channel layer 47.

The electrode layer 45 may reflect the light incident from the light emitting structure 17, so that the light extraction efficiency may be improved.

The electrode layer 45 may make ohmic contact with the light emitting structure 17, so that the current may flow into the light emitting structure 17.

The electrode layer 45 may be formed in single layer having a mixture of a reflective material and an ohmic material. In this case, there is no need to separately form the reflective layer and the ohmic contact layer to form the electrode layer 45. For example, the reflective material may include at least one selected from Ag, Ni, Al, Rh, Pd, Ir, Ru, Mg, Zn, Pt, Au and Hf, or an alloy thereof, but the embodiment is not limited thereto. The ohmic contact material may include a transparent conductive material. For example, the ohmic contact material may include at least one selected from the group consisting of ITO (indium tin oxide), IZO (indium zinc oxide), IZTO (indium zinc tin oxide), IAZO (indium aluminum zinc oxide), IGZO (indium gallium zinc oxide), IGTO (indium gallium tin oxide), AZO (aluminum zinc oxide), ATO(antimony tin oxide), GZO (gallium zinc oxide), IrOx, RuOx, RuOx/ITO, Ni, Ag, Ni/IrOx/Au, and Ni/IrOx/Au/ITO.

The electrode layer 45 may be formed in a multi-layer structure including one of IZO/Ni, AZO/Ag, IZO/Ag/Ni and AZO/Ag/Ni.

The current blocking layer 49 may be formed on the electrode layer 45. The current blocking layer may be formed to make contact with the bottom surface of the light emitting structure 17. At least a portion of the current blocking layer 49 may vertically overlap with the electrode 55.

The current blocking layer 49 may be formed on the top surface of the electrode layer 45, but the embodiment is not limited thereto. That is, although not shown, the current blocking layer 49 may be formed on the bottom surface of the light emitting structure 17, the bottom surface of the electrode layer 45 or the top surface of the bonding layer 43.

The current blocking layer 49 may make Schottky contact with the light emitting structure 17. Thus, the current does not smoothly supplied into the light emitting structure 17 making schottky contact with the current blocking layer 49.

The channel layer 47 may be formed on the electrode layer 45. For example, the channel layer 47 may be formed around the edge region of the electrode layer 45. That is, the channel layer 47 may be formed on circumference region between the light emitting structure 17 and the electrode layer 45.

The channel layer 47 prevents a short circuit from being formed between the side surface of the bonding layer 43 and the side surface of the light emitting structure 17 due to an external foreign substance. In addition, by securing an area on which the channel layer 47 makes contact with the light emitting structure 17, when a laser scribing process for dividing the plurality of chips into individual chip units and a laser lift off process for removing a substrate (reference numeral 1 of FIG. 1) are performed, the light emitting structure 17 may be effectively prevented from being delaminated from the electrode layer 45.

The channel layer 47 may include an insulation material. For example, the channel layer 47 may include at least one selected from the group consisting of SiO₂, SiOₓ, SiOₓN_{y}, Si₃N₄, and Al₂O₃. Further, the channel layer 47 may be formed of a metallic material, but the embodiment is not limited thereto.

The light emitting structure 17 may be formed on the electrode layer 45, the channel layer 47 and the current blocking layer 49.

The side surface of the light emitting structure 17 may be perpendicularly formed or inclined through an etching process which is performed for dividing the plurality of chips into individual chip units. For example, the side surface of the light emitting structure 17 may be formed through an isolation etching.

The light extraction structure 53 for extracting light may be formed on the top surface of the first conductive semiconductor layer 11.

The light extraction structure 53 may be formed by the seed pattern 7 depicted in FIG. 1. The seed pattern 7 may have a function of forming the first semiconductor layer 9. The seed pattern 7 may be formed from the top surfaces of the plurality of protrusions 3 and then the portions between the seed patterns 7 may be merged after a predetermined time has elapsed, so that the first semiconductor layer 9 may be formed. Thus, the concavo-convex pattern may be formed by the seed pattern 7 until the first semiconductor layer 9 is formed from the top surfaces of the protrusions 3, so that the light extraction may be increased by the concavo-convex pattern.

Thus, since there is no need to additionally form the light extraction structure 53 in the vertical-type light emitting device, the process may be simplified and the process time may be reduced.

The light extraction structure 53 may have a roughness structure, but the embodiment is not limited thereto.

The electrode 55 may be formed on the first conductive semiconductor layer 11.

The electrode 55 may have a pattern shape partly formed without covering the entire area of the light emitting structure 17.

The protective layer 51 may be formed on the light emitting structure 17. For example, the protective layer 51 may be formed at least on the side surface of the light emitting structure 17.

The protective layer 51 may prevent the light emitting structure 17 from being short-circuited to the supporting substrate 41 and in addition, may protect the vertical-type light emitting device against an impact from an outside. For example, the protective layer 51 may include one selected from the group consisting of SiO₂, SiOₓ, SiOₓN_{y}, Si₃N₄, TiO₂ and Al₂O₃, but the embodiment is not limited thereto.

FIG. 13 is a sectional view showing a light emitting device package according to an embodiment.

Referring to FIG. 13, the light emitting device package according to the embodiment includes a body 101, first and second lead electrodes 103 and 105 installed in the body 101, a light emitting device 10 installed on the body 101 to receive an electric power from the first and second lead electrodes 103 and 105 according to the first and second embodiments, and a molding member 113 surrounding the light emitting device 10.

The body 101 may include a silicon material, a polysilicon resin material or a metallic material, and an inclined surface may be formed around the light emitting device 10.

The first and second lead electrodes 103 and 105 are electrically separated from each other, and the electric power is supplied to the light emitting device 10 through the first and second lead electrodes 103 and 105.

Further, the first and second lead electrodes 103 and 105 may reflect the light generated from the light emitting device 10 so that the light efficiency may be increased, and may dissipates the heat generated from the light emitting device 10.

The light emitting device may be mounted on one of the first and second lead electrodes 103 and 105 and the body 101 and may be electrically connected to the first and second lead electrodes 103 and 105 through a wire bonding scheme or a die bonding scheme, but the embodiment is not limited thereto.

Although it is exemplarily proposed in the embodiment that the light emitting device 10 is electrically connected to one of the first and second lead electrodes 103 and 105 through one wire 109, the embodiment is not limited thereto and the light emitting device 10 may be electrically connected to the first and second lead electrodes 103 and 105 through two wires. In addition, the light emitting device 10 may be electrically connected to the first and second lead electrodes 103 and 105 without using any wires.

The molding member 113 surrounds the light emitting device 10, so that the molding member 113 may protect the light emitting device 10. In addition, the molding member 113 may include a fluorescent material so that the wavelength of light emitted from the light emitting device may be changed.

The light emitting package 200 according to the embodiment may include a COB (Chip on Board) type of a light emitting package. The top surface of the light emitting package may be flat and a plurality of light emitting devices may the body 101 may be installed on the body 101.

The light emitting device or the light emitting package according to the embodiment may be applied to a light unit. The light unit may be applied to a display, a lighting apparatus and a unit such as a lamp, a traffic light, a vehicle headlight, an electric signboard or an indicator light.

According to the embodiment, due to the protrusions formed on the substrate, the light extraction efficiency may be improved.

According to the embodiment, due to the medium layer formed between the protrusions formed on substrate, the light extraction efficiency may be more improved.

According to the embodiment, by forming the first semiconductor layer or the light emitting structure on only the protrusions, the crystalline property of the light emitting structure is improved so that the optical and electrical properties may be improved.

According to the embodiment, since the medium layer formed between the protrusions have a light reflecting function when the embodiment is applied to the lateral type light emitting device, the light extraction efficiency may be improved.

According to the embodiment, the medium layer formed between the protrusions constitutes the light extraction structure when the embodiment is applied to the flip-type light emitting device, so that the light extraction efficiency may be improved.

According to the embodiment, the seed pattern constitutes the light extraction structure when the embodiment is applied to the vertical type light emitting device, so that the light extraction efficiency may be improved.

## Claims

1. A light emitting device comprising:
a substrate (1);
a plurality of protrusions (3) protruding from a top surface of the substrate (1);
a first semiconductor layer (9) ;a plurality of seed patterns (7) protruding from a bottom surface of the first semiconductor layer toward the protrusions, the bottom surface of each of the seed patterns (7) contacting the top surface of each of the protrusions (3);
a medium layer (5) surrounded by the substrate (1), the protrusions (3), the seed patterns (7) and the first semiconductor layer (9) and
a light emitting structure (17) disposed on a top surface of the first semiconductor layer,
**characterized in that** each of the protrusions (3) includes six inclined side surfaces and the top flat surface on the six inclined side surfaces..

2. The light emitting device of claim 1 , wherein side surfaces of the seed patterns (7) are asymmetrical to side surfaces of the protrusions (3) with respect to top surfaces of the protrusions (3), respectively.

3. The light emitting device of any one of claim 1 our 2 , wherein a bottom surface of each of the seed patterns (7) has a narrower with than that of a top surface of each of the seed patterns (7).

4. The light emitting device of any one of claims 1 to 3, wherein side surfaces of the seed patterns (7) protrude in an a-plane direction of the protrusions (3) rather than a direction having an angle of ±15° with respect to the a-plane of the protrusions (3).

5. The light emitting device of any one of claims 1 to 4, wherein the medium layer (5) contacts the substrate, the protrusions (3), the seed patterns (7) and the first semiconductor layer (9).

6. The light emitting device of any one of claims 1 to 5, wherein side surfaces of the protrusions (3) are inclined at an angle in a range of 90° to 150° with respect to the top surfaces of the protrusions (3).

7. The light emitting device of any one of claims 1 to 6, wherein the medium layer (5) includes a liquid or air.

8. The light emitting device of any one of claims 1 to 7, wherein the first semiconductor layer (9) includes a buffer layer or an n-type semiconductor layer.

9. The light emitting device of any one of claims 1 to 8, wherein the substrate and the protrusions (3) include a sapphire material, wherein the first semiconductor layer (9) includes one of GaN, InN, AlGaN and InGaN.

10. The light emitting device of any one of claims 1 to 9, wherein a height of each protrusion is greater than a thickness of each of seed patterns (7).

11. The light emitting device of any one of claims 4 to 10, wherein a bottom surface of each of the seed patterns (7) has a narrower with than that of a top portion of each of the seed patterns (7).

12. The light emitting device of claim 11, wherein entire bottom surfaces of the seed patterns (7) overlap with top surfaces of the protrusions (3) in a vertical direction.

13. The light emitting device of claim 11 or 12, wherein the top surface of each of the protrusions and the bottom surface of each of the seed pattern is formed in a hexagonal shape.

14. The light emitting device of any one of claims 1 to 13, wherein the first semiconductor layer (9) includes the same material as that of the seed patterns (7).

## Patentansprüche

1. Lichtemittierungsvorrichtung umfassend:
ein Substrat (1);
eine Vielzahl von Vorsprüngen (3), die von einer oberen Oberfläche des Substrats (1) vorstehen;
eine erste Halbleiterschicht (9); eine Vielzahl von Saatmustern (7), die von einer unteren Oberfläche der ersten Halbleiterschicht in. Richtung der Vorsprünge vorstehen, wobei die untere Oberfläche von jedem der Saatmuster (7) die obere Oberfläche von jedem der Vorsprünge (3) kontaktiert;
eine Mittelschicht (5), die von dem Substrat (1), den Vorsprüngen (3), den Saatmustern (7) und der ersten Halbleiterschicht (9) umgeben ist, und
eine Lichtemittierungsstruktur (17), die an einer oberen Oberfläche der ersten Halbleiterschicht angeordnet ist,
**dadurch gekennzeichnet, dass** jeder der Vorsprünge (3) sechs geneigte Seitenflächen und eine obere flache Oberfläche auf den sechs geneigten Seitenflächen umfasst.

2. Lichtemittierungsvorrichtung nach Anspruch 1, wobei Seitenflächen der Saatmuster (7) zu Seitenflächen der Vorsprünge (3) jeweils bezüglich oberen Oberflächen der Vorsprünge (3) asymmetrisch sind.

3. Lichtemittierungsvorrichtung nach einem der Ansprüche 1 oder 2, wobei eine untere Oberfläche von jedem der Saatmuster (7) eine schmälere Breite als jene einer oberen Oberfläche von jedem der Saatmuster (7) aufweist.

4. Lichtemittierungsvorrichtung nach einem der Ansprüche 1 bis 3, wobei Seitenflächen der Saatmuster (7) in einer a-Ebenen-Richtung der Vorsprünge (3) anstatt in einer Richtung mit einem Winkel von ±15° bezüglich der a-Ebene der Vorsprünge (3) vorstehen.

5. Lichtemittierungsvorrichtung nach einem der Ansprüche 1 bis 4, wobei die Mittelschicht (5) das Substrat, die Vorsprünge (3), die Saatmuster (7) und die erste Halbleiterschicht (9) kontaktiert.

6. Lichtemittierungsvorrichtung nach einem der Ansprüche 1 bis 5, wobei Seitenflächen der Vorsprünge (3) in einem Winkel in einem Bereich von 90° bis 150° bezüglich der oberen Oberflächen der Vorsprünge (3) geneigt sind.

7. Lichtemittierungsvorrichtung nach einem der Ansprüche 1 bis 6, wobei die Mittelschicht (5) eine Flüssigkeit oder Luft umfasst.

8. Lichtemittierungsvorrichtung nach einem der Ansprüche 1 bis 7, wobei die erste Halbleiterschicht (9) eine Pufferschicht oder eine n-leitende Halbleiterschicht umfasst.

9. Lichtemittierungsvorrichtung nach einem der Ansprüche 1 bis 8, wobei das Substrat und die Vorsprünge (3) ein Saphirmaterial umfassen, wobei die erste Halbleiterschicht (9) GaN, InN, AlGaN und InGaN umfasst.

10. Lichtemittierungsvorrichtung nach einem der Ansprüche 1 bis 9, wobei eine Höhe von jedem Vorsprung größer als eine Dicke von jedem der Saatmuster (7) ist.

11. Lichtemittierungsvorrichtung nach einem der Ansprüche 4 bis 10, wobei eine untere Oberfläche von jedem der Saatmuster (7) eine geringere Breite als jene eines oberen Abschnitts von jedem der Saatmuster (7) aufweist.

12. Lichtemittierungsvorrichtung nach Anspruch 11, wobei gesamte untere Oberflächen der Saatmuster (7) mit oberen Oberflächen der Vorsprünge (3) in einer vertikalen Richtung überlappen.

13. Lichtemittierungsvorrichtung nach Anspruch 11 oder 12, wobei die obere Oberfläche von jedem der Vorsprünge und die untere Oberfläche von jedem der Saatmuster in einer hexagonalen Form ausgebildet ist.

14. Lichtemittierungsvorrichtung nach einem der Ansprüche 1 bis 13, wobei die erste Halbleiterschicht (9) das gleiche Material wie jenes der Saatmuster (7) umfasst.

## Revendications

1. Dispositif électroluminescent comportant :
un substrat (1),
une pluralité de protubérances (3) faisant saillie à partir d'une surface supérieure du substrat (1),
une première couche semi-conductrice (9),
une pluralité de motifs germinaux (7) faisant saillie à partir d'une surface inférieure de la première couche semi-conductrice vers les protubérances, la surface inférieure de chacun des motifs germinaux (7) étant en contact avec la surface supérieure de chacune des protubérances (3),
une couche centrale (5) entourée par le substrat (1), les protubérances (3), les motifs germinaux (7) et la première couche semi-conductrice (9) et
une structure électroluminescente (17) disposée sur une surface supérieure de la première couche semi-conductrice,
**caractérisé en ce que** chacune des protubérances (3) comprend six surfaces latérales inclinées et la surface plane supérieure sur les six surfaces latérales inclinées.

2. Dispositif électroluminescent selon la revendication 1, dans lequel des surfaces latérales des motifs germinaux (7) sont asymétriques à des surfaces latérales des protubérances (3) par rapport à des surfaces supérieures des protubérances (3), respectivement.

3. Dispositif électroluminescent selon l'une quelconque des revendications 1 ou 2, dans lequel une surface inférieure de chacun des motifs germinaux (3) a une largeur plus étroite que celle d'une surface supérieure de chacun des motifs germinaux (7).

4. Dispositif électroluminescent selon l'une quelconque des revendications 1 à 3, dans lequel des surfaces latérales des motifs germinaux (7) font saillie dans une direction de plan a des protubérance (3) plutôt que dans une direction ayant un angle de ± 15° par rapport au plan a des protubérances (3).

5. Dispositif électroluminescent selon l'une quelconque des revendications 1 à 4, dans lequel la couche centrale (5) est en contact avec le substrat, les protubérances (3), les motifs germinaux (7) et la première couche semi-conductrice (9).

6. Dispositif électroluminescent selon l'une quelconque des revendications 1 à 5, dans lequel des surfaces latérales des protubérances (3) sont inclinées à un angle dans une plage de 90° à 150° par rapport aux surfaces supérieures des protubérances (3).

7. Dispositif électroluminescent selon l'une quelconque des revendications 1 à 6, dans lequel la couche centrale (5) comprend un liquide ou de l'air.

8. Dispositif électroluminescent selon l'une quelconque des revendications 1 à 7, dans lequel la première couche semi-conductrice (9) comprend une couche tampon ou une couche semi-conductrice de type n.

9. Dispositif électroluminescent selon l'une quelconque des revendications 1 à 8, dans lequel le substrat et les protubérances (3) comprennent un saphir, dans lequel la première couche semi-conductrice (9) comprend un élément parmi GaN, InN, AlGaN et InGaN.

10. Dispositif électroluminescent selon l'une quelconque des revendications 1 à 9, dans lequel une hauteur de chaque protubérances est plus grande qu'une épaisseur de chacun des motifs germinaux (7).

11. Dispositif électroluminescent selon l'une quelconque des revendications 4 à 10, dans lequel une surface inférieure de chacun des motifs germinaux (7) a une largeur plus étroite que celle d'une portion supérieure de chacun des motifs germinaux (7).

12. Dispositif électroluminescent selon la revendications 11, dans lequel des surfaces intérieures complètes des motifs germinaux (7) chevauchent des surfaces supérieures des protubérances (3) dans une direction verticale.

13. Dispositif électroluminescent selon la revendication 11 ou 12, dans lequel la surface supérieure de chacune des protubérances et la surface inférieure de chacun des motifs germinaux sont formées dans une forme hexagonale.

14. Dispositif électroluminescent selon l'une quelconque des revendications, 1 à 13, dans lequel la première couche semi-conductrice (9) comprend le même matériau que celui des motifs germinaux (7).
